Europäisches Patentamt

European Patent Office

Office européen des brevets

(11) Publication number: **0 326 970 B1**

# EUROPEAN PATENT SPECIFICATION

(45) Date of publication of patent specification: **23.12.92**

(51) Int. Cl.⁵: **H05K 7/10**

(21) Application number: **89101475.5**

(22) Date of filing: **27.01.89**

(54) **Socket.**

(30) Priority: **03.02.88 JP 13388/88 U**

(43) Date of publication of application:
**09.08.89 Bulletin 89/32**

(45) Publication of the grant of the patent:
**23.12.92 Bulletin 92/52**

(84) Designated Contracting States:
**BE DE FR GB IT NL**

(56) References cited:
**FR-A- 2 276 757**
**US-A- 4 358 173**

**30TH Electronic Components Conference 28
April 1980, SAN FRANCISCO, US pages 349 -
354; MOLLEN: "IBM Pluggable Modules"**

(73) Proprietor: **JAPAN AVIATION ELECTRONICS
INDUSTRY, LIMITED
21-6, Dogenzaka 1-chome
Shibuya-ku Tokyo(JP)**

Proprietor: **NEC CORPORATION
7-1, Shiba 5-chome Minato-ku
Tokyo 108-01(JP)**

(72) Inventor: **Ichimura, Yoshiaki Japan Aviation
Elect. Ind. Ltd.
21-6, Dogenzaka 1-chome Shibuya-ku
Tokyo(JP)**
Inventor: **Ishizuka, Shinichi Japan Aviation
Elect. Ind. Ltd.
21-6, Dogenzaka 1-chome Shibuya-ku
Tokyo(JP)**
Inventor: **Komoto, Mitsuo c/o NEC Corpora-
tion
33-1, Shiba 5-chome
Minato-ku Tokyo(JP)**
Inventor: **Umesato, Shoji c/o NEC Corporation
33-1, Shiba 5-chome
Minato-ku Tokyo(JP)**

(74) Representative: **Blumbach Weser Bergen
Kramer Zwirner Hoffmann Patentanwälte
Radeckestrasse 43
W-8000 München 60(DE)**

EP 0 326 970 B1

# Description

## BACKGROUND OF THE INVENTION

The present invention relates to a socket for connecting, for example, a PGA (Pin Grid Array) type IC to an electric circuit.

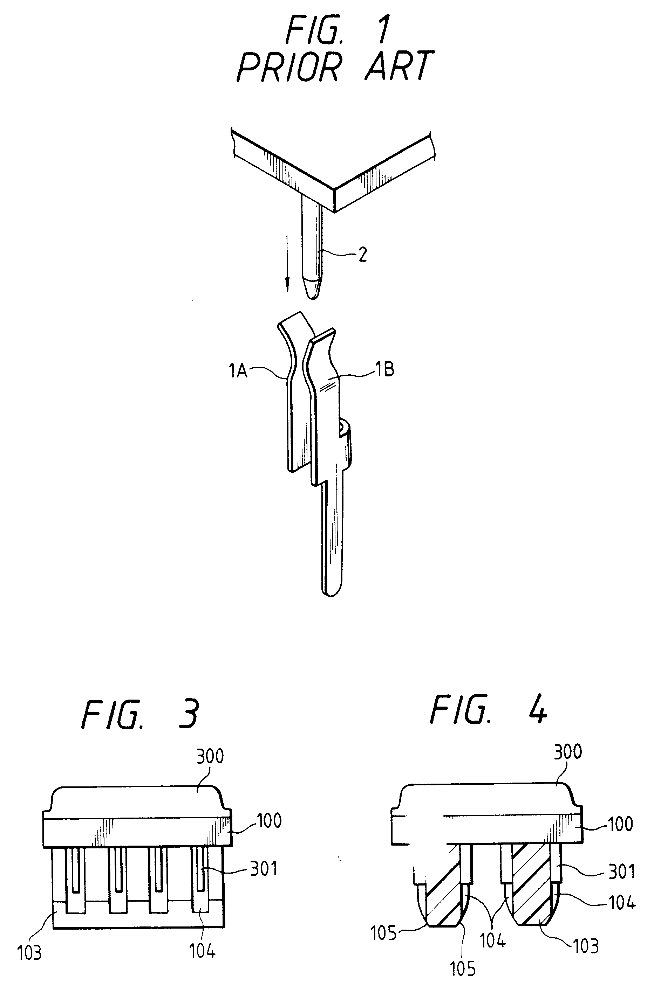

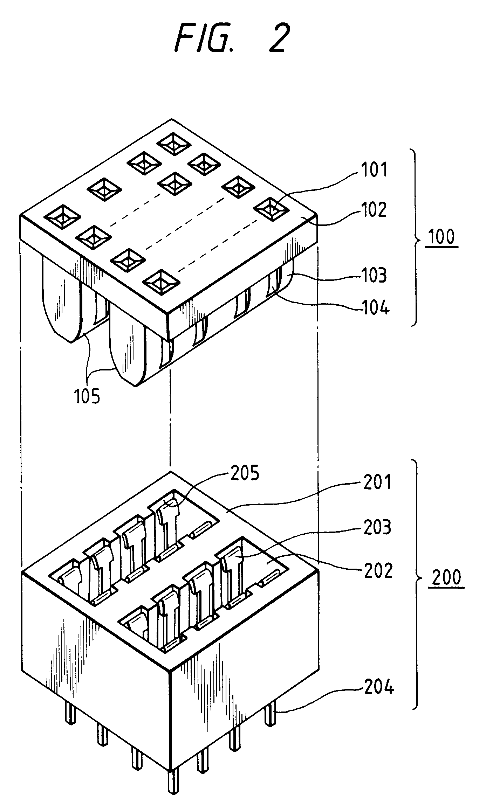

Contacts heretofore employed in sockets for IC's usually have such a structure as shown in Fig. 1, for instance, in which a pair of opposed contact pieces 1A and 1B are received in a contact receiving hole made in a housing (not shown) and a pin 2 of an IC is forced into the space defined by the contact pieces 1A and 1B to make electrical contact therewith, see also 30th Electronic Components Conference, 28th/April 1980, San Francisco, US, pages 349-354; MOLLEN: "IBM Pluggable Modules".

With an increase in the integration density of IC's, the number of pins used also increases and some IC's have as many as hundreds of pins. Such IC's are commonly referred to as the PGA (Pin Grid Array) type, because the pins are protrusively provided in the form of a grid on an insulating package formed flat.

With an increase in the number of pins, their cross-sectional area decreases, inevitably leading to a decrease in their mechanical strength. Consequently, the conventional contact is not suitable for use in the socket for the PGA type IC in that when the IC is plugged into the socket, pins of the IC are readily deformed or broken, resulting in bad contact. Moreover, there is the possibility of the IC package being broken by large force which is needed for fitting hundreds of pins into contacts at one time.

Similar problems are encountered not only in IC's but also in other parts when the number of pins used is large.

## SUMMARY OF THE INVENTION

It is therefore an object of the present invention to provide a socket into which a member to be connected can be plugged without applying excessive force to its pins and hence with no fear of deforming the pins and which does not need large force for plugging thereinto the member to be connected.

According to the present invention as claimed, the socket is made up of a cover which includes a flat insulating member having arrays of pin insertion holes made therethrough for insertion of pins of a member to be connected, an insulating protrusion protrusively provided on the underside of the flat insulating member, with its side wall surfaces lying along the arrays of pin insertion holes, and grooves cut in the side wall surfaces of the insulating protrusions for receiving the pins inserted through the pin insertion holes, and a socket body which includes an insulating housing having a recess made therein for receiving the insulating protrusion of the cover, contact pieces held on side walls of the recess for making contact with the pins received in the grooves of the insulating protrusion, and terminals electrically conducting to the contact pieces, respectively, and led out of the insulating housing on the side opposite from the cover.

With such an arrangement, the member to be connected and the cover are assembled into a unitary structure, with the pins of the former inserted into the pin insertion holes of the latter, and then the insulating protrusion of the cover is pressed into the recess of the socket body. In this case, the pins of the member to be connected are respectively received in the grooves of the insulating protrusion but slightly protrude out of the grooves, since the depth of each groove is selected a little smaller than the diameter of each pin. Consequently, when the insulating protrusion is pressed into the recess of the socket body, the contact pieces held on the side walls of the recess make contact with the pins, establishing the electrical connection between the terminals and the member to be connected.

Thus, according to the present invention, since the pins of the member to be connected are inserted into and pulled out of the socket body while being received in the grooves cut in the cover, no excessive force is applied to the pins, and consequently, the pins are not likely to be bent or broken when they are pressed into or pulled out of the socket body. Further, since the member to be connected is protected by the cover, the force for pressing the member into or pulling it out of the socket body is applied mainly to the cover, not directly to the package of the member to be connected. It is therefore possible to prevent that the member to be connected is broken when it is inserted into or pulled out of the socket body.

## BRIEF DESCRIPTION OF THE DRAWINGS

Fig. 1 is a perspective view, for explaining the structure of a contact of a conventional socket;

Fig. 2 is an exploded perspective view illustrating an embodiment of the present invention;

Fig. 3 is a side view showing the state in which a member to be connected is mounted on a cover for use in the present invention;

Fig. 4 is a diagram, partly in section, for explaining the state in which the member to be connected is mounted on the cover;

Fig. 5 is a sectional view, for explaining the state in which the member to be connected, mounted on the cover, is engaged with the socket body;

and

Fig. 6 is a graph showing force for insertion into the socket of the present invention and the conventional one.

## DESCRIPTION OF THE PREFERRED EMBODIMENT

Fig. 2 illustrates an embodiment of the present invention. Reference numeral 100 indicates a cover and 200 a socket body. In this embodiment a member to be connected is an IC.

The cover 100 has a flat insulating member 102 which has pin insertion holes 101 arranged in the form of a grid, insulating protrusions 103 molded integrally with the flat insulating member 102 and projecting from its underside transversely thereof, and U-shaped grooves 104 cut in both sides of each insulating projection 103. The insulating projections 103 are each disposed with its side walls extending across the pin receiving holes 101 so that the grooves 104 communicate with the holes 101, respectively. The depth of each groove 104 is selected slightly smaller than the diameter (or thickness) of a pin 301 of an IC 300 (see Figs. 3 to 5). When inserted into the groove 104 through the pin insertion hole 101, the pin 301 of the IC 300 is held a little protruding out of the groove 104.

The insulating protrusions 103 in this example are shown to be provided between arrays of the pin insertion holes 101. In this example, the pin insertion holes 101 are arrayed in four lines and the insulating protrusions 103 are provided in two lines accordingly. When the pin insertion holes 101 are arrayed in N lines, N/2 protrusions 103 are provided. The lower end portion of each insulating protrusion 103 is rounded at corners to form slopes 105 (see Figs. 2 and 4).

The socket body 200 comprises an insulating housing 201, recesses 202 formed in the top of the insulating housing 201 for receiving the insulating protrusions 103, contact pieces 203 attached to side walls of the recesses 202, and terminals 204 each formed electrically as one body with the corresponding contact piece 203 and led out of the socket body 200 on the opposite side from the cover 100.

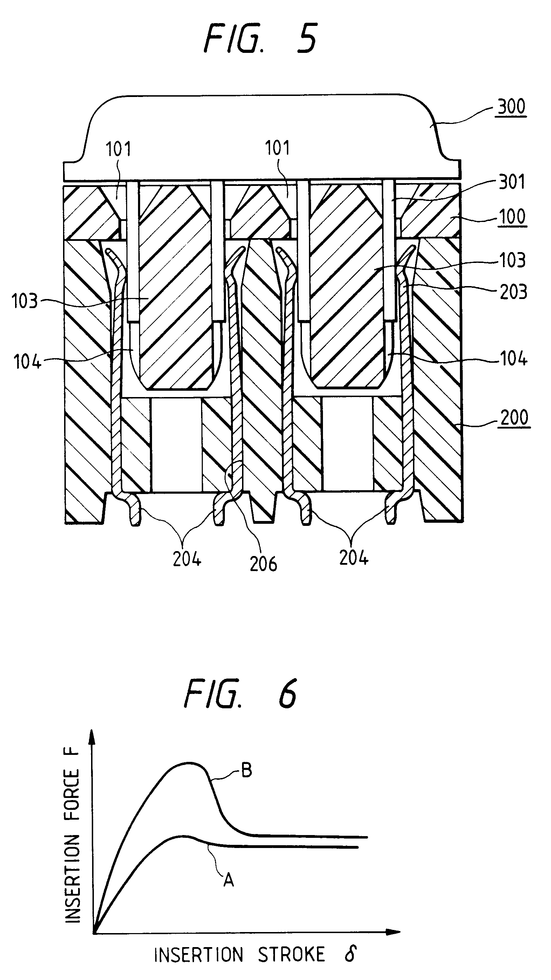

The recesses 202 in this example are each provided in the form of a narrow trough so as to receive the insulating protrusion 103 of the cover 100. The contact pieces 203 are held in grooves 205 cut in both side walls of the recesses 202 in opposing relation to the grooves 104 of the insulating protrusions 103. Each contact piece 203 is made of a conductive resilient material and supported by a cantilever structure in which its upper end portion is made free but its lower end portion is pressed into and secured to a slit 206 made in the bottom of the insulating housing 201 (Fig. 5). The upper free end portion of the contact piece 203 is prebiased toward the axis of the recess 202, and when the insulating protrusion 103 of the cover 100 is inserted into the recess 202, the contact piece 203 is resiliently biased toward the side wall of the recess 202 against the spring force of its own but, by virtue of its restoring force, the contact piece 203 makes contact with the pin 301 of the IC 300.

With such an arrangement as described above, the IC 300 is plugged into the socket by inserting all the pins 301 of the IC 300 into the grooves 104 of the insulating protrusions 103 through the pin insertion holes 101 of the cover 100 and then pressing the insulating protrusions 103 into the recesses 202 of the socket body 300 while urging the IC 300 against the cover 100. In this instance, each pair of opposed contact pieces 203 are spread out by the slopes 105 of the insulating protrusion 103 and, at the same time, guided to the position where the corresponding pins 301 are exposed out of the grooves 104, and as the insulating protrusion 103 is further pressed into the recess 202, the contact pieces 203 are further guided to override the pins 301 as shown in Fig. 5. In this state the contact pieces 203 contact, by the spring force of their own, the pins 301 and remain in good contact with them.

As described above, according to the present invention, the pins 301 of the IC 300 are received in the grooves 104 cut in the cover 100 and, in such a protected state, they are engaged with and disengaged from the socket body 200. This eliminates the possibility of the pins 301 being bent or broken when they are pressed into contact with the contact pieces 203.

Furthermore, since the contact pieces 203 are gradually pressed outward by the slopes 105 of the insulating protrusions 103 when they come into contact with the pins 301, the force for pressing the insulating protrusions 103 into the recesses 202 can be reduced.

Fig. 6 shows the force for insertion into the socket of the present invention, in comparison with the force for insertion into the conventional socket, the curve A being an insertion stroke vs. insertion force characteristic of the socket according to the present invention and the curve B the insertion stroke vs. insertion force of the conventional socket.

As will be seen from Fig. 6, according to the conventional socket, when pins of a member to be connected thereto begin to contact the contact pieces, the insertion force abruptly increases because the pins directly thrust the contact pieces aside. (At this time, excessive force is applied to the pins, often bending or breaking them.)

In contrast thereto, since the socket of the present invention has a structure in which the contact pieces 203 are gradually pushed aside by the insulating protrusions 103 of the socket cover 100 and then guided to override the pins 301 received in the grooves 104 of the insulating protrusions 103 but slightly sticking out therefrom, the insertion force only gently changes throughout the entire inserting operation and no large insertion force is needed.

As will be appreciated from the above, the present invention offers a highly reliable socket which is free from the possibility of breaking or bending the pins even if a member to be connected is frequently engaged with and disengaged from the socket. Moreover, even if the member to be connected has a large number of pins, there is no fear of breaking its package, because the insertion force needed is small.

The present invention offers another advantage that the pins of the member to be connected can be protected during its transportation if the cover 100 is held attached to the member to be connected.

**Claims**

1. A socket comprising:
   (A) a cover 100 including a flat insulating member 102 having a plurality of arrays of holes 101 made therethrough for insertion of pins 301 of a member 300 to be connected to the socket, at least one insulating protrusion 103 protrusively provided on the underside of the flat insulating member, with its side wall surfaces lying along the arrays of pin insertion holes, and guide grooves 104 cut in the side wall surfaces of the insulating protrusion for guiding the pins 301 inserted through the pin insertion holes; and
   (B) a socket body 200 including an insulating housing having at least one recess 202 made therein for receiving the insulating protrusion 103 of the cover, a plurality of contact pieces 203 held on side walls of the recess for making contact with the pins 301 guided by the guide grooves, and terminals 204 electrically conducting to the contact pieces and led out of the insulating housing on the side opposite from the cover.

2. The socket of claim 1, wherein the side walls of the recess formed in the insulating housing have contact piece positioning grooves 205 opposite the guide grooves, respectively.

3. The socket of claim 1, wherein the insulating protrusion is provided every two arrays of pin insertion holes between them and extends in the direction of the arrays of pin insertion holes and the guide grooves are formed in both side wall surfaces of each of such insulating protrusions.

4. The socket of claim 3, wherein the contact pieces 203 are held along the opposed side walls of the recess.

5. The socket of claim 1, 2, 3 or 4, wherein the lower end portion of the insulating protrusion has slopes at both sides.

6. The socket of claim 1, 2, 3 or 4, wherein each of the contact pieces is a long, narrow plate-like member, its front end being free and bent toward the side wall of the recess and its rear end being fixed to the insulating housing.

7. The socket of claim 1, 2, 3 or 4, wherein at least two insulating protrusions are provided in parallel.

**Patentansprüche**

1. Fassung, umfassend:
   (A) einen Deckel 100, der ein flaches isolierendes Element (102) enthält, welches eine Vielzahl von Reihen von Löchern (101) aufweist, die das Element durchsetzend zum Einführen von Stiften (301) eines an der Fassung anzuschließenden Elements (300) ausgebildet sind, wobei wenigstens ein isolierender Vorsprung (103) an der Unterseite des flachen isolierenden Elements vorspringend vorgesehen ist und seine Seitenwandflächen längs den Reihen von Stifteinstecklöchern liegen sowie Führungsnuten (104) in die Seitenwandflächen des isolierenden Vorsprungs zur Führung der Stifte (301) eingeschnitten sind, welche durch die Stifteinstecklöcher eingesteckt werden; und
   (B) einen Fassungskörper (200), der ein isolierendes Gehäuse, in welchem wenigstens eine Ausnehmung (202) zur Aufnahme des isolierenden Vorsprungs (103) des De-ckels ausgebildet ist, eine Vielzahl von Kontaktstücken (203), die an den Seitenwänden der Ausnehmung gehalten werden, um Kontakt mit den von den Führungsnuten geführten Stiften (301) herzustellen, und Anschlüsse (204) enthält, die elektrisch zu den Kontaktstücken geführt sind und an der dem Dek-kel entgegengesetzten Seite aus dem isolierenden Gehäuse herausgeführt sind.

**2.** Fassung nach Anspruch 1, bei der die Seitenwände der Ausnehmung, die in dem isolierenden Gehäuse ausgebildet ist, Kontaktstückpositionierungsnuten (205) jeweils den Führungsnuten gegenüberliegend aufweisen.

**3.** Fassung nach Anspruch 1, bei der der isolierende Vorsprung jeweils pro zwei Reihen von Stifteinstecklöchern zwischen diesen vorgesehen ist und sich in der Richtung der Reihen von Stifteinstecklöchern erstreckt, wobei die Führungsnuten in beiden Seitenwandflächen jedes solchen isolierenden Vorsprungs ausgebildet sind.

**4.** Fassung nach Anspruch 3, bei der die Kontaktstücke (203) längs den gegenüberliegenden Seitenwänden der Ausnehmung gehalten werden.

**5.** Fassung nach Anspruch 1, 2, 3 oder 4, bei der die unteren Endabschnitte des isolierenden Vorsprungs auf beiden Seiten Neigungen aufweist.

**6.** Fassung nach Anspruch 1, 2, 3 oder 4, bei der jedes der Kontaktstücke ein langes, schmales, plattenartiges Element ist, dessen vorderes Ende frei und zur Seitenwand der Ausnehmung hin gebogen ist und dessen hinteres Ende am isolierenden Gehäuse befestigt ist.

**7.** Fassung nach Anspruch 1, 2, 3 oder 4, bei der wenigstens zwei isolierende Vorsprünge parallel zueinander vorgesehen sind.

**Revendications**

**1.** Socle comprenant :
(A) un couvercle (100) comprenant un élément isolant plat (102) comportant une pluralité de rangées de trous (101) le traversant pour l'insertion de broches (301) d'un élément (300) à raccorder au socle, au moins une projection isolante (103) se projetant sur le dessous de l'élément isolant plat, avec ses surfaces de parois latérales se trouvant le long des rangées de trous d'insertion de broches, et des rainures de guidage (104) découpées dans les surfaces de parois latérales de la projection isolante pour guider les broches (301) insérées dans les trous d'insertion de broches; et
(B) un corps de socle (200) comprenant un boîtier isolant comportant au moins un évidement (202) en son sein pour recevoir la projection isolante (103) du couvercle, une pluralité de pièces de contact (203) fixées sur les parois latérales de l'évidement pour faire contact avec les broches (301) guidées par les rainures de guidage, et des bornes (204) conduisant éléectriquement aux pièces de contact et sortant du boîtier isolant sur le côté à l'opposé du couvercle.

**2.** Socle selon la revendication 1, dans lequel les parois latérales de l'évidement formé dans le boîtier isolant comportent des rainures (205) de positionnement de pièces de contact à l'opposé des rainures de guidage, respectivement.

**3.** Socle selon la revendication 1, dans lequel la projection isolante est disposée toutes les deux rangées de trous d'insertion de broches entre lesdites rangées et s'étend dans la direction des rangées de trous d'insertion de broches et les rainures de guidage sont formées dans les deux surfaces de parois latérales de chacune desdites projections isolantes.

**4.** Socle selon la revendication 3, dans lequel les pièces de contact (203) sont fixées le long des parois latérales opposées de l'évidement.

**5.** Socle selon la revendication 1, 2, 3 ou 4, dans lequel la portion d'extrémité inférieure de la projection isolante comporte des pentes sur les deux côtés.

**6.** Socle selon la revendication 1, 2, 3 ou 4, dans lequel chacune des pièces de contact est un élément en forme de plaque, long, étroit, son extrémité avant étant libre et courbée vers la paroi latérale de l'évidement et son extrémité arrière étant fixée au boîtier isolant.

**7.** Socle selon la revendication 1, 2, 3 ou 4, dans lequel au moins deux projections isolantes sont disposées parallèlement.

EP 0 326 970 B1

# FIG. 1
# PRIOR ART

2

1A     1B

# FIG. 3

300
100
301
103     104

# FIG. 4

300
100
301
104
105     104     103
105

6

# FIG. 2

## FIG. 5

## FIG. 6